# EUROPÄISCHE PATENTSCHRIFT

(11) **EP 3 192 135 B1**
(45) Veröffentlichungstag und Bekanntmachung des Hinweises auf die Patenterteilung: **24.11.2021**
(21) Anmeldenummer: 15760121.2
(22) Anmeldetag: 27.08.2015
(51) Int. Cl.: H01S 5/02, H01S 5/22

(54) **VERFAHREN ZUM HERSTELLEN EINES LASERCHIPS**
METHOD FOR PRODUCING A LASER CHIP
PROCÉDÉ DE FABRICATION D'UNE PUCE DE LASER

(30) Priorität: 08.09.2014 DE 102014112902
(43) Veröffentlichungstag der Anmeldung: 19.07.2017
(73) Patentinhaber: OSRAM Opto Semiconductors GmbH, 93055 Regensburg (DE)
(72) Erfinder: GERHARD, Sven, 93087 Alteglofsheim (DE); ADLHOCH, Thomas, 93179 Brennberg (DE); VEIT, Thomas, 93098 Mintraching (DE); LELL, Alfred, 93142 Maxhütte-Haidhof (DE); PFEIFFER, Joachim, 93083 Obertraubling (DE); MUELLER, Jens, 93053 Regensburg (DE); EICHLER, Christoph, 93053 Donaustauf (DE)
(74) Vertreter: Patentanwaltskanzlei WILHELM & BECK
(86) Internationale Anmeldenummer: PCT/EP2015/069698
(87) Internationale Veröffentlichungsnummer: WO 2016/037863

(56) Entgegenhaltungen:
- US-A1- 2009 137 098
- US-A1- 2009 262 771
- US-A1- 2010 301 348
- None

## Beschreibung

Die vorliegende Erfindung betrifft ein Verfahren zum Herstellen eines Laserchips gemäß Patentanspruch 1.

Diese Patentanmeldung beansprucht die Priorität der deutschen Patentanmeldung 10 2014 112 902.4.

Halbleiter-Laserchips mit integrierten Laserdioden sind aus dem Stand der Technik bekannt. Die Patentschrift US 2009/137098 zeigt solche Laserchips. Die Patentschrift offenbart ein Verfahren zum Herstellen eines Laserchips mit den folgenden Schritten: Bereitstellen einer Halbleiterscheibe mit einer Oberseite und einer Unterseite, wobei die Halbleiterscheibe eine Mehrzahl integrierter Laserdiodenstrukturen aufweist, die entlang einer festgelegten Bruchrichtung hintereinander angeordnet sind; Anlegen einer Mehrzahl von entlang der Bruchrichtung hintereinander angeordneten Vertiefungen an der Oberseite der Halbleiterscheibe,wobei jede Vertiefung in Bruchrichtung aufeinanderfolgend eine vordere Begrenzungsfläche und eine hintere Begrenzungsfläche aufweist,wobei bei mindestens einer Vertiefung die hintere Begrenzungsfläche gegenüber der Oberseite der Halbleiterscheibe um einen Winkel zwischen 95° und 170° geneigt ist, wobei mindestens eine Vertiefung einen an die hintere Begrenzungsfläche anschließenden Absatz aufweist, wobei der Absatz eine zur Oberseite der Halbleiterscheibe parallele Absatzfläche aufweist, die an die hintere Begrenzungsfläche anschließt; Brechen der Halbleiterscheibe in Bruchrichtung an einer senkrecht zur Oberseite der Halbleiterscheibe orientierten Bruchebene, die durch die Vertiefungen verläuft.

Somit ist es bekannt, eine Mehrzahl solcher Laserchips gleichzeitig in gemeinsamen Arbeitsgängen herzustellen, indem in einer ausgedehnten Halbleiterscheibe (Wafer) mehrere Laserdiodenstrukturen in einer regelmäßigen Matrixanordnung ausgebildet und erst nach Abschluss der Bearbeitungsprozess durch Zerteilen der Halbleiterscheibe vereinzelt werden. Das Zerteilen der Halbleiterscheibe erfolgt durch kontrolliertes Brechen der Halbleiterscheibe. Jeweils zwei einander gegenüberliegende Bruchflächen der auf diese Weise gebildeten Laserchips bilden Spiegelfacetten der Laserchips.

Zur Festlegung der Bruchebenen, entlang derer die Halbleiterscheibe gebrochen wird somit vor dem Brechen der Halbleiterscheibe an der Oberfläche der Halbleiterscheibe Vertiefungen (Skips) anzulegen. Allerdings hat sich gezeigt, dass sich während des Brechens der Halbleiterscheibe, ausgehend von diesen Vertiefungen, Versetzungen und andere Kristallstörungen im Kristall der Halbleiterscheibe ausbreiten können, welche sich bis in aktive Bereiche der Laserdiodenstrukturen erstrecken und die Qualität der entstehenden Spiegelfacetten reduzieren können. Dies kann erhöhte Schwellströme, eine reduzierte Steilheit, Fehler in der Abbildungsqualität, eine verringerte Effizienz und eine reduzierte Bauteil-Lebensdauer zur Folge haben.

Eine Aufgabe der vorliegenden Erfindung besteht darin, ein Verfahren zum Herstellen eines Laserchips anzugeben. Diese Aufgabe wird durch ein Verfahren mit den Merkmalen des Anspruchs 1 gelöst. In den abhängigen Ansprüchen sind verschiedene Weiterbildungen angegeben.

Ein Verfahren zum Herstellen eines Laserchips umfasst Schritte zum Bereitstellen einer Halbleiterscheibe mit einer Oberseite und einer Unterseite, wobei die Halbleiterscheibe eine Mehrzahl integrierter Laserdiodenstrukturen aufweist, die entlang einer festgelegten Bruchrichtung hintereinander angeordnet sind, zum Anlegen einer Mehrzahl von entlang der Bruchrichtung hintereinander angeordneten Vertiefungen an der Oberseite der Halbleiterscheibe, wobei jede Vertiefung in Bruchrichtung aufeinander folgend eine vordere Begrenzungsfläche und eine hintere Begrenzungsfläche aufweist, wobei bei mindestens einer Vertiefung die hintere Begrenzungsfläche gegenüber der Oberseite der Halbleiterscheibe um einen Winkel zwischen 95° und 170° geneigt ist, und zum Brechen der Halbleiterscheibe in Bruchrichtung an einer senkrecht zur Oberseite der Halbleiterscheibe orientierten Bruchebene, die durch die Vertiefungen verläuft.

Vorteilhafterweise bewirkt die gegenüber der Oberseite der Halbleiterscheibe um einen Winkel geneigte hintere Begrenzungsfläche der mindestens einen Vertiefung der an der Oberseite der Halbleiterscheibe angeordneten Vertiefungen bei diesem Verfahren, dass von der hinteren Begrenzungsfläche der Vertiefung ausgehende Versetzungen und andere Kristallstörungen sich in dem Kristall der Halbleiterscheibe zur Unterseite der Halbleiterscheibe hin fortpflanzen und dadurch nicht in einen für die Qualität des durch das Verfahren erhältlichen Laserchips kritischen Bereich der Halbleiterscheibe vordringen können. Dadurch reduziert sich vorteilhafterweise eine Gefahr einer Verschlechterung der Eigenschaften des durch das Verfahren erhältlichen Laserchips durch während des Brechens der Halbleiterscheibe gebildete Kristallstörungen.

Es ist bevorzugt, dass die hinteren Begrenzungsflächen möglichst vieler oder sogar aller an der Oberseite der Halbleiterscheibe hintereinander angeordneter Vertiefungen gegenüber der Oberseite der Halbleiterscheibe um einen Winkel zwischen 95° und 170° geneigt sind. Hierdurch kann erreicht werden, dass bei allen entsprechend ausgebildeten Vertiefungen an der Oberseite der Halbleiterscheibe die Gefahr einer Bildung von Kristallstörungen, die sich in kritische Bereiche der Halbleiterscheibe fortpflanzen, reduziert wird.

In einer Ausführungsform des Verfahrens ist zwischen zwei benachbarten Laserdiodenstrukturen je eine Vertiefung angeordnet. Es hat sich erwiesen, dass dadurch eine zuverlässige Festlegung der Bruchebene, an der die Halbleiterscheibe gebrochen wird, möglich ist, ohne dass die Halbleiterscheibe dabei durch eine übermäßig hohe Anzahl von Vertiefungen übermäßig geschädigt wird.

In einer Ausführungsform des Verfahrens ist mindestens eine Vertiefung näher an einer in Bruchrichtung vor der Vertiefung nächstgelegenen Laserdiodenstruktur angeordnet als an einer in Bruchrichtung hinter der Vertiefung nächstgelegenen Laserdiodenstruktur. Dies bedeutet, dass der Abstand zwischen der in Bruchrichtung vor der Vertiefung nächstgelegenen Laserdiodenstruktur und der Vertiefung kleiner ist als der Abstand zwischen der Vertiefung und der in Bruchrichtung hinter der Vertiefung nächstgelegenen Laserdiodenstruktur. Dadurch verbleibt für von der hinteren Begrenzungsfläche der Vertiefung ausgehende Kristallstörungen vorteilhafterweise ausreichend Platz, um in Richtung der Unterseite der Halbleiterscheibe in ein Substrat der Halbleiterscheibe auszulaufen, ohne in einen für die Qualität der in Bruchrichtung hinter der Vertiefung nächstgelegenen Laserdiodenstruktur kritischen Bereich der Halbleiterscheibe vorzudringen. Dadurch sinkt vorteilhafterweise die Gefahr, dass die in Bruchrichtung hinter der Vertiefung nächstgelegene Laserdiodenstruktur während des Brechens der Halbleiterscheibe durch von der Vertiefung ausgehende Kristallstörungen geschädigt wird.

In einer bevorzugten Ausführungsform des Verfahrens sind mehrere oder sogar alle Vertiefungen an der Oberseite der Halbleiterscheibe entsprechend näher an der jeweils in Bruchrichtung vor der jeweiligen Vertiefung nächstgelegenen Laserdiodenstruktur angeordnet als an der in Bruchrichtung hinter der jeweiligen Vertiefung nächstgelegenen Laserdiodenstruktur.

In einer Ausführungsform des Verfahrens ist der Abstand zwischen der Vertiefung und der in Bruchrichtung hinter der Vertiefung nächstgelegenen Laserdiodenstruktur mindestens viermal so groß wie der Abstand zwischen der Vertiefung und der in Bruchrichtung vor der Vertiefung nächstgelegenen Laserdiodenstruktur, bevorzugt sogar mindestens achtmal so groß. Vorteilhafterweise hat sich erwiesen, dass ein derart großer Abstand zwischen der Vertiefung und der in Bruchrichtung hinter der Vertiefung nächstgelegenen Laserdiodenstruktur eine wirksame Reduzierung eines Risikos einer Beschädigung der hinter der Vertiefung nächstgelegenen Laserdiodenstruktur durch während des Brechens der Halbleiterscheibe von der hinteren Begrenzungsfläche der Vertiefung ausgehende Kristallstörungen bewirken kann.

In einer Ausführungsform des Verfahrens weist jede der Laserdiodenstrukturen einen Resonator auf, der senkrecht zur Bruchrichtung orientiert ist. Dadurch werden während des Brechens der Halbleiterscheibe an der Bruchebene Spiegelfacetten beziehungsweise Laserfacetten der so vereinzelten Laserchips gebildet. Diese Facetten können vorteilhafterweise eine hohe Qualität aufweisen. Es besteht durch die Ausgestaltung der an der Oberseite der Halbleiterscheibe angeordneten Vertiefung mit der gegenüber der Oberseite der Halbleiterscheibe um einen Winkel geneigten hinteren Begrenzungsfläche nur eine geringe Gefahr, dass die Facetten während des Brechens der Halbleiterscheibe durch von der Vertiefung ausgehende Kristallstörungen geschädigt werden.

In einer Ausführungsform des Verfahrens werden die Vertiefungen durch Ritzen oder mittels eines Lasers angelegt. Vorteilhafterweise ermöglichen beide Methoden eine präzise Kontrolle der sich ergebenden Form der Vertiefungen, insbesondere eine präzise Kontrolle über die Neigung der hinteren Begrenzungsfläche der Vertiefung.

In einer Ausführungsform des Verfahrens umfasst dieses einen weiteren Schritt zum Anlegen einer in der Bruchebene angeordneten Randkerbe an einem in Bruchrichtung vorne liegenden Rand der Halbleiterscheibe. Vorteilhafterweise kann die Randkerbe während des Brechens der Halbleiterscheibe als Ausgangspunkt für den sich entlang der Bruchebene in Bruchrichtung durch die Halbleiterscheibe fortsetzenden Bruch dienen. Die Randkerbe kann beispielsweise ebenfalls durch Ritzen oder mittels eines Lasers angelegt werden.

Das erfindungsgemäße Verfahren umfasst einen weiteren Schritt zum Anlegen eines in Bruchrichtung verlaufenden und in der Bruchebene angeordneten Grabens an der Unterseite der Halbleiterscheibe. Vorteilhafterweise kann das Anlegen des Grabens an der Unterseite der Halbleiterscheibe das Brechen der Halbleiterscheibe erleichtern.

In einer Ausführungsform des Verfahrens erfolgt das Anlegen des Grabens durch Sägen, mittels eines Lasers oder durch einen Ätzprozess. Vorteilhafterweise erlauben diese Methoden ein präzises, kostengünstiges und schnelles Anlegen des Grabens.

In einer nicht beanspruchten Ausführungsform des Verfahrens umfasst dieses einen weiteren Schritt zum Anlegen einer Mehrzahl von in der Bruchebene und entlang der Bruchrichtung hintereinander angeordneten Vertiefungen an der Unterseite der Halbleiterscheibe. Vorteilhafterweise können auch solche an der Unterseite der Halbleiterscheibe angeordneten Vertiefungen das Brechen der Halbleiterscheibe an der Bruchebene erleichtern.

In einer nicht beanspruchten Ausführungsform des Verfahrens werden die Vertiefungen an der Unterseite der Halbleiterscheibe spiegelbildlich zu den Vertiefungen an der Oberseite der Halbleiterscheibe ausgebildet. Dies bedeutet, dass bei mindestens einer, bevorzugt aber bei vielen oder sogar allen der Vertiefungen an der Unterseite der Halbleiterscheibe eine in Bruchrichtung hintere Begrenzungsfläche gegenüber der Unterseite der Halbleiterscheibe um einen Winkel zwischen 95° und 170° geneigt ist.

Dies hat zur Folge, dass von der hinteren Begrenzungsfläche einer derart ausgebildeten Vertiefung an der Unterseite der Halbleiterscheibe ausgehende Kristallstörungen im Wesentlichen in Richtung senkrecht zur Unterseite der Halbleiterscheibe durch die Halbleiterscheibe verlaufen und dabei Kristallstörungen abfangen können, die von einer an der Oberseite der Halbleiterscheibe angeordneten Vertiefung ausgehen. Die an der Unterseite der Halbleiterscheibe angeordneten Vertiefungen können dabei in Bruchrichtung genau unterhalb der an der Oberseite der Halbleiterscheibe angeordneten Vertiefungen angeordnet sein. Die an der Oberseite der Halbleiterscheibe angeordneten Vertiefungen und die an der Unterseite der Halbleiterscheibe angeordneten Vertiefungen können aber auch in Bruchrichtung gegeneinander versetzt sein.

In einer Ausführungsform des Verfahrens ist bei mindestens einer Vertiefung die hintere Begrenzungsfläche gegenüber der Oberseite der Halbleiterscheibe um einen Winkel zwischen 100° und 160° geneigt, bevorzugt um einen Winkel zwischen 120° und 145°. Experimente haben gezeigt, dass durch eine derartige Neigung der hinteren Begrenzungsfläche gegenüber der Oberseite der Halbleiterscheibe eine besonders wirkungsvolle Ablenkung von von der hinteren Begrenzungsfläche der Vertiefung ausgehenden Kristallstörungen in Richtung zur Unterseite der Halbleiterscheibe erreicht werden kann.

In einer Ausführungsform des Verfahrens weist mindestens eine Vertiefung in zur Oberseite der Halbleiterscheibe senkrechte Richtung eine Tiefe auf, die zwischen 5 µm und 80 µm liegt, bevorzugt zwischen 15 µm und 70 µm, besonders bevorzugt zwischen 25 µm und 55 µm. Bevorzugt werden mehrere oder alle Vertiefungen an der Oberseite der Halbleiterscheibe derart ausgebildet. Experimente haben gezeigt, dass durch Vertiefungen dieser Tiefe eine besonders wirksame Festlegung der Bruchebene erreicht werden kann, ohne dass durch das Anlegen der Vertiefung eine übermäßig starke Schädigung des Kristalls der Halbleiterscheibe bewirkt wird.

In einer Ausführungsform des Verfahrens ist bei mindestens einer Vertiefung die vordere Begrenzungsfläche gegenüber der Oberseite der Halbleiterscheibe um einen Winkel zwischen 75° und 95° geneigt, bevorzugt um einen Winkel zwischen 85° und 95°. Dies bedeutet, dass die vordere Begrenzungsfläche der Vertiefung im Wesentlichen senkrecht zur Oberseite der Halbleiterscheibe angeordnet ist. Bevorzugt werden mehrere oder alle Vertiefungen an der Oberseite der Halbleiterscheibe derart ausgebildet. Es hat sich gezeigt, dass während des Brechens der Halbleiterscheibe von den vorderen Begrenzungsflächen der Vertiefungen im Wesentlichen keine Kristallstörungen ausgehen, sodass diese nicht gegenüber der Oberseite der Halbleiterscheibe geneigt werden müssen. Die im Wesentlichen senkrechte Anordnung der vorderen Begrenzungsflächen gegenüber der Oberseite der Halbleiterscheibe lässt sich vorteilhafterweise besonders einfach und kostengünstig erzeugen.

In einer Ausführungsform des Verfahrens weist mindestens eine Vertiefung an ihrem Grund in Bruchrichtung eine Länge auf, die zwischen 5 µm und 100 µm liegt, bevorzugt zwischen 15 µm und 80 µm, besonders bevorzugt zwischen 20 µm und 50 µm. Bevorzugt werden mehrere oder sogar alle Vertiefungen an der Oberseite der Halbleiterscheibe derart ausgebildet. Experimente haben gezeigt, dass durch das Anlegen von Vertiefungen dieser Länge an der Oberseite der Halbleiterscheibe die Bruchebene zum Brechen der Halbleiterscheibe besonders wirksam festgelegt werden kann, ohne dass das Anlegen der Vertiefungen mit einer übermäßig starken Schädigung der Kristallstruktur der Halbleiterscheibe einhergeht.

Mindestens eine Vertiefung weist einen an die hintere Begrenzungsfläche anschließenden Absatz auf. Dabei weist der Absatz eine zur Oberseite der Halbleiterscheibe parallele Absatzfläche auf, die an die hintere Begrenzungsfläche anschließt. In einer bevorzugten Ausführungsform des Verfahrens werden mehrere oder sogar alle Vertiefungen an der Oberseite der Halbleiterscheibe derart ausgebildet. Während des Brechens der Halbleiterscheibe an der Bruchebene können von der Absatzfläche des Absatzes der Vertiefung Kristallstörungen ausgehen, die sich im Wesentlichen senkrecht zur Absatzfläche durch den Kristall der Halbleiterscheibe fortsetzen, also auch senkrecht zur Oberseite der Halbleiterscheibe. Die von der Absatzfläche ausgehenden Kristallstörungen pflanzen sich damit in Richtung zur Unterseite der Halbleiterscheibe fort, ohne in für die Qualität des durch das Verfahren erhältlichen Laserchips kritische Bereiche der Halbleiterscheibe vorzudringen. Vielmehr können von der Absatzfläche des Absatzes der Vertiefung ausgehende Kristallstörungen noch von der hinteren Begrenzungsfläche der Vertiefung ausgehende Kristallstörungen abfangen, wodurch die Gefahr eines Vordringens von von der hinteren Begrenzungsfläche der Vertiefung ausgehender Kristallstörungen in für die Qualität des durch das Verfahren erhältlichen Laserchips kritische Bereiche der Halbleiterscheibe zusätzlich reduziert wird.

In einer Ausführungsform des Verfahrens weist die Absatzfläche in Bruchrichtung eine Länge zwischen 5 µm und 100 µm auf, bevorzugt eine Länge zwischen 15 µm und 80 µm, besonders bevorzugt eine Länge zwischen 20 µm und 50 µm. Es hat sich gezeigt, dass das Ausbilden der Absatzfläche einer derartigen Länge besonders wirkungsvoll ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematisierter Darstellung
Fig. 1 eine perspektivische Ansicht eines Teils einer Halbleiterscheibe;
Fig. 2 eine geschnittene Darstellung der Halbleiterscheibe mit ersten oberen Vertiefungen;
Fig. 3 eine geschnittene Darstellung der Halbleiterscheibe mit zweiten oberen Vertiefungen; und
Fig. 4 eine geschnittene Darstellung der Halbleiterscheibe mit zusätzlichen unteren Vertiefungen.

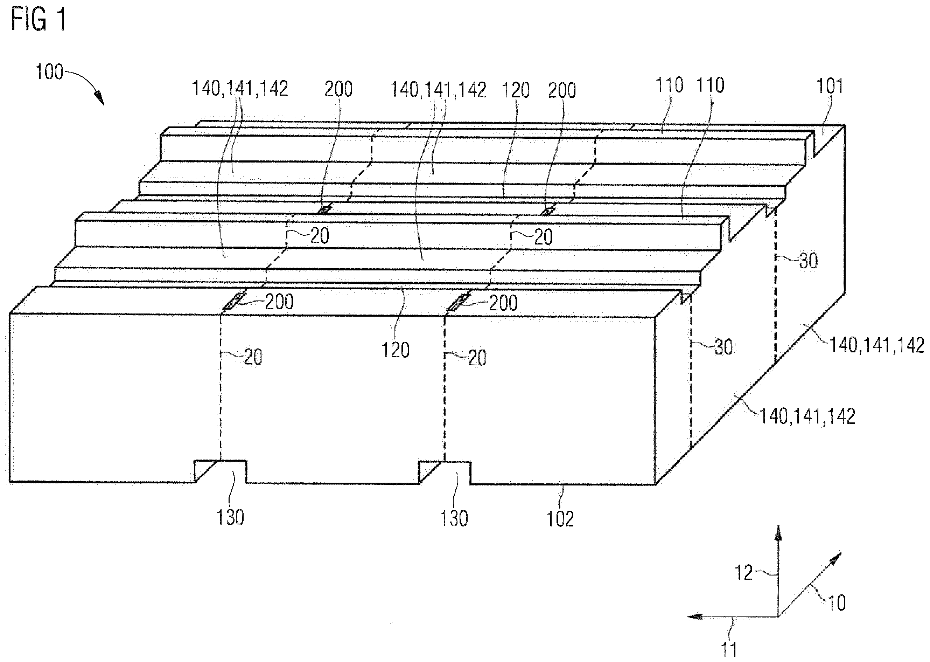

Fig. 1 zeigt eine schematische perspektivische Darstellung eines Teils einer Halbleiterscheibe 100. Die Halbleiterscheibe 100 ist als im Wesentlichen flache Scheibe mit einer Oberseite 101 und einer der Oberseite 101 gegenüberliegenden Unterseite 102 ausgebildet. Die Halbleiterscheibe 100 kann eine Mehrzahl unterschiedlicher Schichten aufweisen, die in einer sich von der Unterseite 102 zur Oberseite 101 der Halbleiterscheibe 100 erstreckenden Wachstumsrichtung 12 epitaktisch aufeinander aufgewachsen wurden. Die Halbleiterscheibe 100 kann in laterale Richtung größere Abmessungen aufweisen, als dies in Fig. 1 dargestellt ist. Die Halbleiterscheibe 100 kann beispielsweise durch einen vollständigen Wafer oder durch einen Teil eines Wafers gebildet sein.

Aus der Halbleiterscheibe 100 soll durch Zerteilen der Halbleiterscheibe 100 eine Mehrzahl von Laserchips 140 gebildet werden. Hierzu weist die Halbleiterscheibe 100 eine Mehrzahl integrierter Laserdiodenstrukturen 141 auf. Die einzelnen Laserdiodenstrukturen 141 sind in Reihen angeordnet, die in einer zur Wachstumsrichtung 12 senkrechten Bruchrichtung 10 der Halbleiterscheibe 100 nebeneinander angeordnet sind und sich in eine zur Bruchrichtung 10 und zur Wachstumsrichtung 12 senkrechte Längsrichtung 11 erstrecken.

Jede der Reihen von Laserdiodenstrukturen 141 weist eine sich in Längsrichtung 11 erstreckende Rippe 110 an der Oberseite 101 der Halbleiterscheibe 100 auf. Die Rippen 110 können auch als Ridges bezeichnet werden. Die Rippen 110 sind dadurch gebildet, dass Teile der Halbleiterscheibe 100 an der Oberseite 101 der Halbleiterscheibe 100 in den Bereichen außerhalb der Rippen 110 entfernt worden sind, beispielsweise mittels eines Ätzprozesses. Der an der Oberseite 101 der Halbleiterscheibe 100 entfernte Teil der Halbleiterscheibe 100 kann dabei beispielsweise eine obere Mantelschicht (upper cladding layer) umfassen, wodurch die obere Mantelschicht nur im Bereich der Rippen 110 verbleibt. Die Rippen 110 können in Bruchrichtung 10 beispielsweise eine Breite zwischen 1,8 µm und 40 µm aufweisen. Die sich parallel zur Längsrichtung 11 und zur Wachstumsrichtung 12 erstreckenden Seitenflächen der Rippen 110 können passiviert sein, beispielsweise mit Siliziumnitrid. An der zur Bruchrichtung 10 und zur Längsrichtung 11 parallelen Oberseite der Rippen 110 kann eine Metallisierung angeordnet sein, die zur elektrischen Kontaktierung der aus der Halbleiterscheibe 100 zu bildenden Laserchips 140 dient, und die beispielsweise eine Stärke von etwa 1 µm aufweisen kann.

Zwischen zwei in Bruchrichtung 10 nebeneinanderliegenden Rippen 110 an der Oberseite 101 der Halbleiterscheibe 100 ist jeweils ein sich in Längsrichtung 11 erstreckender Mesagraben 120 angeordnet. Die Mesagräben 120 sind als kanalförmige Vertiefungen an der Oberseite 101 der Halbleiterscheibe 100 ausgebildet und können sich in zur Wachstumsrichtung 12 entgegengesetzte Richtung beispielsweise bis unterhalb eines pn-Übergangs der Halbleiterscheibe 100 erstrecken. Die Mesagräben 120 können beispielsweise im Wesentlichen rechteckige Querschnitte aufweisen. In Bruchrichtung 10 können die Mesagräben 120 beispielsweise eine Breite von etwa 50 µm aufweisen.

Um die Halbleiterscheibe 100 in die einzelnen Laserchips 140 zu unterteilen, muss die Halbleiterscheibe 100 an zur Längsrichtung 11 senkrechten Bruchebenen 20 und an zur Bruchrichtung 10 senkrechten weiteren Bruchebenen 30 zerteilt werden. Die weiteren Bruchebenen 30 verlaufen dabei durch die Mesagräben 120. Durch das Zerteilen der Halbleiterscheibe 100 an den Bruchebenen 20 werden Laserbarren gebildet, die jeweils eine Mehrzahl in Bruchrichtung 10 nebeneinander angeordneter Laserdiodenstrukturen 141 umfassen. Anschließend werden die Laserbarren an den weiteren Bruchebenen 30 zerteilt, wodurch die einzelnen Laserchips 140 gebildet werden.

Durch das Zerteilen der Halbleiterscheibe 100 an den Bruchebenen 20 werden Spiegelflächen von Resonatoren 142 der einzelnen Laserdiodenstrukturen 141 gebildet. Um qualitativ hochwertige Spiegelflächen zu bilden, erfolgt das Zerteilen der Halbleiterscheibe 100 an den Bruchebenen 20 durch Brechen der Halbleiterscheibe. Hierbei können idealerweise atomar glatte Bruchkanten gebildet werden, was zu qualitativ hochwertigen Spiegelflächen der Resonatoren 142 führt.

Das Brechen der Halbleiterscheibe 100 an den Bruchebenen 20 erfolgt jeweils in Bruchrichtung 10 von einer in Bruchrichtung 10 vorne liegenden und zur Bruchrichtung 10 senkrechten Seitenfläche der Halbleiterscheibe 100 zu einer in Bruchrichtung 10 hinten liegenden und zur Bruchrichtung 10 senkrechten Seitenfläche der Halbleiterscheibe 100. In der schematischen Darstellung der Fig. 1 erfolgt das Brechen der Halbleiterscheibe 100 also beispielsweise von der sichtbaren vorderen Seitenfläche zu der verdeckten hinteren Seitenfläche der Halbleiterscheibe 100.

Das Brechen der Halbleiterscheibe 100 an den Bruchebenen 20 erfolgt jeweils ausgehend von einer definiert angelegten Sollbruchstelle an der in Bruchrichtung 10 vorne liegenden Seitenfläche der Halbleiterscheibe 100. Um den Verlauf des Bruchs der Halbleiterscheibe 100 an der jeweils gewünschten Bruchebene 20 zu führen, werden entlang der gewünschten Bruchebenen 20 weitere Schwächungen an der Oberseite 101 der Halbleiterscheibe 100 vorgesehen.

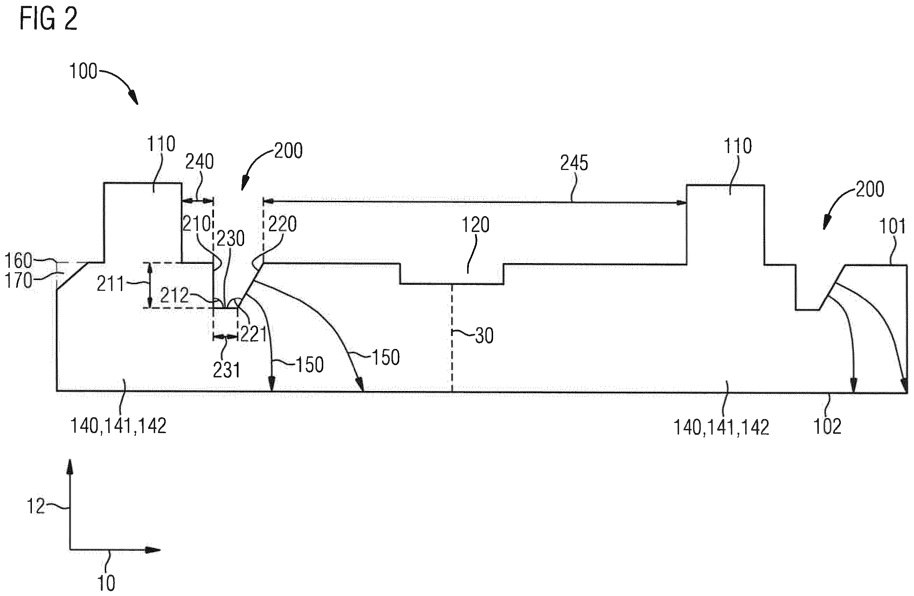

Fig. 2 zeigt eine schematische geschnittene Seitenansicht eines Teils der Halbleiterscheibe 100 100 gemäß einer nicht beanspruchten Ausführungsform. Die Halbleiterscheibe 100 ist dabei an einer der Bruchebenen 20 geschnitten. Die gewünschte Bruchrichtung 10 zum Brechen der Halbleiterscheibe 100 an der Bruchebene 20 erstreckt sich in der schematischen Darstellung der Fig. 2 von links nach rechts, sodass eine in der Darstellung der Fig. 2 linke Seitenfläche der Halbleiterscheibe 100 eine in Bruchrichtung 10 vorne liegende Seitenfläche der Halbleiterscheibe 100 bildet.

Als Startpunkt für den Bruch der Halbleiterscheibe 100 ist an einem in Bruchrichtung 10 vorderen Rand 160 im Übergangsbereich zwischen der in Bruchrichtung 10 vorne liegenden Seitenfläche der Halbleiterscheibe 100 und der Oberseite 101 der Halbleiterscheibe 100 eine Randkerbe 170 angelegt worden. Es ist auch möglich, die Randkerbe 170 im Übergangsbereich zwischen der in Bruchrichtung 10 vorne liegenden Seitenfläche der Halbleiterscheibe 100 und der Unterseite 102 der Halbleiterscheibe 100 anzuordnen, oder die Randkerbe 170 über die ganze vordere Seitenfläche der Halbleiterscheibe 100 zu erstrecken.

Zusätzlich kann auch an der in Bruchrichtung 10 hinten liegenden Seitenfläche der Halbleiterscheibe 100 eine Randkerbe angeordnet werden, was jedoch nicht zwingend erforderlich ist. In jedem Fall erfolgt der Bruch der Halbleiterscheibe 100 in Bruchrichtung 10 von der vorderen Seitenfläche zur hinteren Seitenfläche der Halbleiterscheibe 100.

Zur Führung des Bruchs der Halbleiterscheibe 100 an der Bruchebene 20 weist die Halbleiterscheibe 100 an ihrer Oberseite 101 außerdem mehrere erste obere Vertiefungen 200 auf, die in Bruchrichtung 10 hintereinander entlang der Bruchebene 20 angeordnet sind. Die Vertiefungen 200 können auch als Skips bezeichnet werden.

Die Randkerben 170 und die ersten oberen Vertiefungen 200 können beispielsweise durch Ritzen, beispielsweise mit einem Diamantritzer, oder mittels eines Lasers angelegt werden.

Bevorzugt sind, in Längsrichtung 11 hintereinander, an jeder Bruchebene 20 eine Randkerbe 170 und erste obere Vertiefungen 200 vorgesehen.

Bevorzugt ist an jeder Bruchebene 20 je eine erste obere Vertiefung 200 zwischen zwei in Bruchrichtung 10 aufeinander folgenden Laserdiodenstrukturen angeordnet, somit zwischen zwei in Bruchrichtung 10 aufeinander folgenden Rippen 110. Dabei ist jede erste obere Vertiefung 200 bevorzugt in dem Bereich zwischen der Rippe 110 der in Bruchrichtung 10 vor der jeweiligen ersten oberen Vertiefung 200 angeordneten Laserdiodenstruktur 141 und dem Mesagraben 120 angeordnet, der zwischen den beiden der jeweiligen ersten oberen Vertiefung 200 benachbarten Laserdiodenstrukturen 141 liegt. Damit ist jede erste obere Vertiefung 200 näher an der in Bruchrichtung vor der jeweiligen ersten oberen Vertiefung 200 nächstliegenden Laserdiodenstruktur 141 angeordnet, als an der in Bruchrichtung 10 hinter der jeweiligen ersten oberen Vertiefung 200 nächstgelegenen Laserdiodenstruktur 141. Bevorzugt ist bei jeder ersten oberen Vertiefung 200 ein hinterer Abstand 245 zwischen der jeweiligen ersten oberen Vertiefung 200 und der in Bruchrichtung 10 hinter der jeweiligen ersten oberen Vertiefung 200 nächstgelegenen Laserdiodenstruktur 141 mindestens viermal so groß wie ein vorderer Abstand 240 zwischen der jeweiligen ersten oberen Vertiefung 200 und der in Bruchrichtung 10 vor der jeweiligen ersten oberen Vertiefung 200 nächstgelegenen Laserdiodenstruktur 141, besonders bevorzugt sogar mindestens achtmal so groß. Der vordere Abstand 240 zwischen dem Resonator 142 der vor einer ersten oberen Vertiefung 200 angeordneten Laserdiodenstruktur 141 und der jeweiligen ersten oberen Vertiefung 200 kann beispielsweise ungefähr 20 µm betragen. Der hintere Abstand 245 zwischen einer ersten oberen Vertiefung 200 und dem Resonator 142 der in Bruchrichtung 10 nächsten Laserdiodenstruktur 141 hinter dieser ersten oberen Vertiefung 200 kann beispielsweise ungefähr 200 µm betragen.

Es ist auch möglich, zwischen zwei in Bruchrichtung 10 aufeinander folgenden Laserdiodenstrukturen mehr als eine Vertiefung 200 vorzusehen.

Jede erste obere Vertiefung 200 weist eine in Bruchrichtung 10 vordere Begrenzungsfläche 210 und eine in Bruchrichtung 10 hintere Begrenzungsfläche 220 auf. Die vordere Begrenzungsfläche 210 und die hintere Begrenzungsfläche 220 jeder ersten oberen Vertiefung 200 sind parallel zur Längsrichtung 11 der Halbleiterscheibe 100 orientiert.

An ihrem Grund weist jede erste obere Vertiefung 200 eine Bodenfläche 230 auf, die die vordere Begrenzungsfläche 210 mit der hinteren Begrenzungsfläche 220 verbindet und im Wesentlichen parallel zur Oberseite 101 der Halbleiterscheibe 100 orientiert ist, also parallel zur Bruchrichtung 10 und zur Längsrichtung 11.

Bei jeder ersten oberen Vertiefung 200 schließt die vordere Begrenzungsfläche 210 mit der Bodenfläche 230 einen vorderen Winkel 212 ein. Der vordere Winkel 212 beträgt bevorzugt zwischen 75° und 95°, besonders bevorzugt zwischen 85° und 95°. Dies bedeutet, dass sich die vordere Begrenzungsfläche 210, ausgehend von der Oberseite 101 der Halbleiterscheibe 100, bevorzugt im Wesentlichen senkrecht in die Halbleiterscheibe 100 hinein erstreckt.

Bei jeder ersten oberen Vertiefung 200 schließt die in Bruchrichtung 10 hintere Begrenzungsfläche 220 mit der Bodenfläche 230 einen hinteren Winkel 221 ein. Der hintere Winkel 221 beträgt zwischen 95° und 170°. Dies bedeutet, dass die hintere Begrenzungsfläche 220 gegen die Bodenfläche 230 und gegen die Oberseite 101 der Halbleiterscheibe 100 geneigt ist. Dies hat zur Folge, dass sich jede erste obere Vertiefung 200 von ihrer Bodenfläche 230 zur Oberseite 101 der Halbleiterscheibe 100 hin aufweitet. Bevorzugt weist der hintere Winkel 221 bei jeder ersten oberen Vertiefung 200 eine Größe zwischen 100° und 160° auf, besonders bevorzugt eine Größe zwischen 120° und 145°.

Jede erste obere Vertiefung 200 weist in Wachstumsrichtung 12 eine Tiefe 211 auf. Bevorzugt liegt die Tiefe 211 bei jeder ersten oberen Vertiefung 200 zwischen 5 µm und 80 µm, besonders bevorzugt zwischen 15 µm und 70 µm, ganz besonders bevorzugt zwischen 25 µm und 55 µm.

Die Bodenfläche 230 jeder ersten oberen Vertiefung 200 weist in Bruchrichtung 10 eine Länge 231 auf. Bevorzugt beträgt die Länge 231 bei jeder ersten oberen Vertiefung 200 zwischen 5 µm und 100 µm, besonders bevorzugt zwischen 15 µm und 80 µm, ganz besonders bevorzugt zwischen 20 µm und 50 µm.

Während des Brechens der Halbleiterscheibe 100 in Bruchrichtung 10 an einer der Bruchebenen 20 können sich an den ersten oberen Vertiefungen 200 Kristallstörungen 150 bilden, die sich in der Halbleiterscheibe 100 fortpflanzen. Bei diesen Kristallstörungen 150 kann es sich beispielsweise um stufenförmige Versetzungen handeln. Das Auftreten solcher Kristallstörungen 150 während des Bruchs der Halbleiterscheibe 100 an einer der Bruchebenen 20 kann eine reduzierte Qualität der durch den Bruch der Halbleiterscheibe 100 an der Bruchebene 20 gebildeten Spiegelflächen zur Folge haben. Für die Qualität der entstehenden Spiegelflächen der Resonatoren 142 der durch das Brechen der Halbleiterscheibe 100 gebildeten Laserchips 140 ist es besonders schädlich, wenn sich Kristallstörungen 150 in der Halbleiterscheibe 100 bis zu einem aktiven Bereich einer der Laserdiodenstrukturen 141 fortpflanzen.

Während des Brechens der Halbleiterscheibe 100 in Bruchrichtung 100 an einer der Bruchebenen 20 entstehende Kristallstörungen 150 werden vorrangig an den hinteren Begrenzungsflächen 220 der ersten oberen Vertiefungen 200 gebildet und setzen sich von dort in zur hinteren Begrenzungsfläche 220 senkrechte Richtung fort. Da die hinteren Begrenzungsflächen 220 der ersten oberen Vertiefungen 200 um den hinteren Winkel 221, der größer als ein rechter Winkel ist, gegen die Oberseite 101 der Halbleiterscheibe 100 geneigt sind, wandern die Kristallstörungen 150 von den hinteren Begrenzungsflächen 220 der ersten oberen Vertiefungen 200 in Richtung zur Unterseite 102 der Halbleiterscheibe 100. Dadurch wird das Risiko reduziert, dass an der hinteren Begrenzungsfläche 220 einer ersten oberen Vertiefung 200 gebildete Kristallstörungen 150 sich in Bruchrichtung 10 bis zum aktiven Bereich der der jeweiligen ersten oberen Vertiefung 200 in Bruchrichtung 10 nachfolgenden Laserdiodenstruktur 141 fortsetzen. Dieses Risiko wird außerdem durch den gegenüber dem vorderen Abstand 240 erhöhten hinteren Abstand 245 zwischen der jeweiligen ersten oberen Vertiefung 200 und der in Bruchrichtung 10 hinter der jeweiligen ersten oberen Vertiefung 200 nächstgelegenen Laserdiodenstruktur 141 reduziert.

Bevorzugt sind alle in Bruchrichtung 10 hintereinander angeordneten ersten oberen Vertiefungen 200 aller in Längsrichtung 11 der Halbleiterscheibe 10 hintereinander angeordneten Bruchebenen 20 so ausgebildet wie beschrieben. Es ist jedoch auch möglich, dass nur ein erster Teil der ersten oberen Vertiefungen 200 wie beschrieben ausgebildet und positioniert ist, während ein zweiter Teil der ersten oberen Vertiefungen 200 anders ausgebildet und/oder bezüglich des vorderen Abstands 240 und des hinteren Abstands 245 anders positioniert ist.

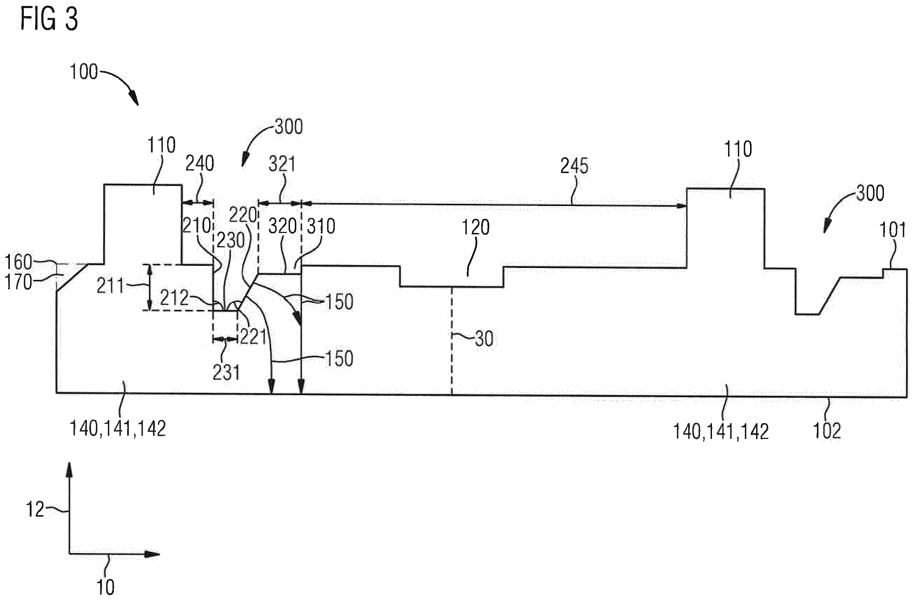

Fig. 3 zeigt eine schematische geschnittene Seitenansicht eines Teils der Halbleiterscheibe 100 gemäß der vorliegenden Erfindung. Auch in der Darstellung der Fig. 3 ist die Halbleiterscheibe 100 an einer der Bruchebenen 20 geschnitten. Die Ausführungsform der Fig. 3 unterscheidet sich von der Ausführungsform der Fig. 2 dadurch, dass die ersten oberen Vertiefungen 200 durch zweite obere Vertiefungen 300 ersetzt sind.

Die zweiten oberen Vertiefungen 300 sind positioniert wie die ersten oberen Vertiefungen 200. Die zweiten oberen Vertiefungen 300 sind ausgebildet wie die ersten oberen Vertiefungen 200, weisen jedoch zusätzlich zu der vorderen Begrenzungsfläche 210, der Bodenfläche 230 und der hinteren Begrenzungsfläche 220 einen Absatz 310 auf, der sich am in Bruchrichtung 10 hinteren Ende der jeweiligen zweiten oberen Vertiefung 300 an die jeweilige hintere Begrenzungsfläche 220 anschließt. Der Absatz 310 jeder zweiten oberen Vertiefung 300 weist eine zur Oberseite 101 der Halbleiterscheibe 100 parallele Absatzfläche 320 auf, die an die jeweilige hintere Begrenzungsfläche 220 anschließt. Diese Absatzfläche 320 weist in Bruchrichtung 10 eine Länge 321 auf. Bevorzugt liegt die Länge 321 der Absatzfläche 320 des Absatzes 310 der zweiten oberen Vertiefungen 300 zwischen 5 µm und 100 µm, besonders bevorzugt zwischen 15 µm und 80 µm, ganz besonders bevorzugt zwischen 20 µm und 50 µm.

Beim Brechen der Halbleiterscheibe 100 in Bruchrichtung 10 an einer der Bruchebenen 20 können auch an den Absatzflächen 320 der Absätze 310 der zweiten oberen Vertiefungen 300 Kristallstörungen 150 entstehen, die sich, ausgehend von der jeweiligen Absatzfläche 320, in eine zur jeweiligen Absatzfläche 320 senkrechte Richtung in die Halbleiterscheibe 100 fortsetzen. Da die Absatzflächen 320 der Absätze 310 der zweiten oberen Vertiefungen 300 parallel zur Oberseite 101 der Halbleiterscheibe 100 orientiert sind, setzen sich von den Absatzflächen 320 der Absätze 310 der zweiten oberen Vertiefungen 300 ausgehende Kristallstörungen 150 im Wesentlichen entgegen der Wachstumsrichtung 12 zur Unterseite 102 der Halbleiterscheibe 100 fort. Damit besteht nur eine geringe Gefahr, dass von den Absatzflächen 320 ausgehende Kristallstörungen 150 zu aktiven Bereichen der Laserstrukturen 141 der Halbleiterscheibe 100 vordringen können.

Zusätzlich können von den Absatzflächen 320 der Absätze 310 der zweiten oberen Vertiefungen 300 ausgehende Kristallstörungen 150 mit von den hinteren Begrenzungsflächen 220 der zweiten oberen Vertiefungen 300 ausgehenden Kristallstörungen 150, die sich in eine senkrecht zu der jeweiligen hinteren Begrenzungsfläche 220 orientierte Richtung fortsetzen, zusammentreffen, und diese von den hinteren Begrenzungsflächen 220 ausgehenden Kristallstörungen 150 damit abfangen. Dadurch können von den Absatzflächen 320 der Absätze 310 der zweiten oberen Vertiefungen 300 ausgehende Kristallstörungen 150 die Gefahr reduzieren, dass von den hinteren Begrenzungsflächen 220 der zweiten oberen Vertiefungen 300 ausgehende Kristallstörungen 150 bis zu aktiven Bereichen der Laserdiodenstrukturen 141 der Halbleiterscheibe 100 vordringen.

In der schematischen perspektivischen Darstellung der Fig. 1 ist erkennbar, dass an der Unterseite 102 der Halbleiterscheibe 100 im Bereich jeder Bruchebene 20 jeweils ein sich in Bruchrichtung 10 erstreckender und in der jeweiligen Bruchebene 20 angeordneter unterer Graben 130 ausgebildet ist. Die unteren Gräben 130 können das Brechen der Halbleiterscheibe 100 an den Bruchebenen 10 erleichtern. Die unteren Gräben 130 können beispielsweise durch Sägen, mittels eines Lasers oder durch nass- oder trockenchemisches Ätzen angelegt werden. Die unteren Gräben 130 werden dabei bevorzugt bereits vor dem Anlegen der oberen Vertiefungen 200, 300 und vor dem Anlegen der Randkerben 170 angelegt.

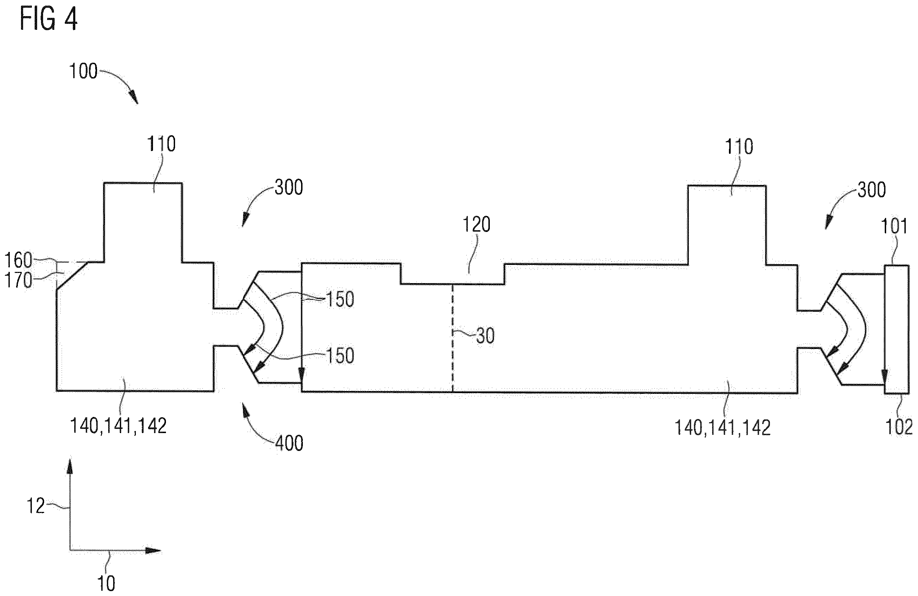

Fig. 4 zeigt eine schematische geschnittene Seitenansicht eines Teils der Halbleiterscheibe 100 gemäß einer weiteren nicht beanspruchten Ausführungsform. In der in Fig. 4 gezeigten Ausführungsform weist die Halbleiterscheibe 100 an ihrer Unterseite 102 keine an den Bruchebenen 20 ausgerichteten unteren Gräben 130 auf. Stattdessen sind an der Unterseite 102 der Halbleiterscheibe 100 jeweils an den Bruchebenen 20 ausgerichtete und in Bruchrichtung 10 hintereinander angeordnete untere Vertiefungen 400 vorgesehen.

Die unteren Vertiefungen 400 sind im in Fig. 4 dargestellten Beispiel spiegelsymmetrisch zu den an der Oberseite 101 der Halbleiterscheibe 100 angeordneten zweiten oberen Vertiefungen 300 angeordnet und ausgebildet. Falls die Halbleiterscheibe 100 anstelle der zweiten oberen Vertiefungen 300 die ersten oberen Vertiefungen 200 der Fig. 2 aufweist, können die unteren Vertiefungen 400 spiegelbildlich zu den ersten oberen Vertiefungen 200 ausgebildet werden. Möglich ist es allerdings auch, an der Oberseite 101 der Halbleiterscheibe 100 die ersten oberen Vertiefungen 200 vorzusehen, und die unteren Vertiefungen 400 an der Unterseite 102 der Halbleiterscheibe 100 wie die zweiten oberen Vertiefungen 300 auszubilden. Auch der umgekehrte Fall ist selbstverständlich möglich.

In der Darstellung der Fig. 4 sind die unteren Vertiefungen 400 entgegen der Wachstumsrichtung 12 jeweils genau unterhalb der zweiten oberen Vertiefungen 300 angeordnet. Es ist jedoch auch möglich, die zweiten oberen Vertiefungen 300 und die unteren Vertiefungen 400 in Bruchrichtung 10 gegeneinander versetzt anzuordnen. Beispielsweise können die unteren Vertiefungen 400 in Bruchrichtung 10 jeweils hinter den zugeordneten zweiten oberen Vertiefungen 300 angeordnet sein.

Beim Brechen der Halbleiterscheibe 100 in Bruchrichtung 10 an einer der Bruchebenen 20 können Kristallstörungen 150 auch an den hinteren Begrenzungsflächen der unteren Vertiefungen 400 gebildet werden. Diese an den hinteren Begrenzungsflächen der unteren Vertiefungen 400 gebildeten Kristallstörungen 150 setzen sich in zur hinteren Begrenzungsfläche der jeweiligen unteren Vertiefung 400 senkrechte Richtung in der Halbleiterscheibe 100 fort und verlaufen damit in Richtung zur Oberseite 101 der Halbleiterscheibe 100. Dabei können sie mit Kristallstörungen 150 zusammentreffen, die von hinteren Begrenzungsflächen 220 der gegenüberliegenden oberen Vertiefungen 300 ausgehen. In diesem Fall können sich die zusammentreffenden Kristallstörungen 150 gegenseitig abfangen und damit eine weitere Fortsetzung der Kristallstörungen 150 in der Halbleiterscheibe 100 verhindern. Dadurch wird das Risiko reduziert, dass von den Vertiefungen 300, 400 ausgehende Kristallstörungen 150 zu aktiven Bereichen der Laserdiodenstrukturen 141 der Halbleiterscheibe 100 vordringen.

### Bezugszeichenliste

- 10: Bruchrichtung
- 11: Längsrichtung
- 12: Wachstumsrichtung
- 20: Bruchebene
- 30: weitere Bruchebene

- 100: Halbleiterscheibe
- 101: Oberseite
- 102: Unterseite

- 110: Rippe
- 120: Mesagraben
- 130: unterer Graben

- 140: Laserchip
- 141: Laserdiodenstruktur
- 142: Resonator

- 150: Kristallstörung

- 160: vorderer Rand
- 170: Randkerbe

- 200: erste obere Vertiefungen
- 210: vordere Begrenzungsfläche
- 211: Tiefe
- 212: vorderer Winkel
- 220: hintere Begrenzungsfläche
- 221: hinterer Winkel
- 230: Bodenfläche
- 231: Länge
- 240: vorderer Abstand
- 245: hinterer Abstand

- 300: zweite obere Vertiefungen
- 310: Absatz

- 320: Absatzfläche
- 321: Länge

- 400: untere Vertiefung

## Patentansprüche

1. Verfahren zum Herstellen eines Laserchips (140) mit den folgenden Schritten:
- Bereitstellen einer Halbleiterscheibe (100) mit einer Oberseite (101) und einer Unterseite (102),
wobei die Halbleiterscheibe (100) auf der Oberseite eine Mehrzahl integrierter Laserdiodenstrukturen (141) aufweist, die entlang einer festgelegten Bruchrichtung (10), welche senkrecht zur Wachstumsrichtung (12)der Halbleiterscheibe verläuft, hintereinander angeordnet sind;
- Anlegen einer Mehrzahl von entlang der Bruchrichtung (10) hintereinander angeordneten Vertiefungen (300) an der Oberseite (101) der Halbleiterscheibe (100),
wobei jede Vertiefung (300) in Bruchrichtung (10) aufeinanderfolgend eine vordere Begrenzungsfläche (210) und eine hintere Begrenzungsfläche (220) aufweist,
wobei die Vertiefung (300) auf ihrem Grund eine Bodenfläche (230) aufweist, die die vordere Begrenzungsfläche (210) mit der hinteren Begrenzungsfläche (220) verbindet und im Wesentlichen parallel zur Oberseite (101) der Halbleiterscheibe (100) orientiert ist,
wobei bei mindestens einer Vertiefung (300) die hintere Begrenzungsfläche (220) mit der Bodenfläche (230) einen Winkel (221) zwischen 95° und 170° einschließt, wobei die mindestens eine Vertiefung (300) einen an die hintere Begrenzungsfläche (220) anschließenden Absatz (310) aufweist, wobei der Absatz (310) eine zur Oberseite (101) der Halbleiterscheibe (100) parallele Absatzfläche (320) aufweist, die an die hintere Begrenzungsfläche (220) anschließt;
- Anlegen eines in Bruchrichtung (10) verlaufenden und in einer Bruchebene (20) angeordneten Grabens (130) an der Unterseite (102) der Halbleiterscheibe (100),
wobei die Bruchebene (20) senkrecht zur Oberseite (101) der Halbleiterscheibe (100) orientiert ist und durch die Vertiefungen (300) verläuft;
- Brechen der Halbleiterscheibe (100) in Bruchrichtung (10) an der Bruchebene (20).

2. Verfahren gemäß Anspruch 1,
wobei zwischen zwei benachbarten Laserdiodenstrukturen (141) je eine Vertiefung (300) angeordnet ist.

3. Verfahren gemäß Anspruch 2,
wobei mindestens eine Vertiefung (300) näher an einer in Bruchrichtung (10) vor der Vertiefung (300) nächstgelegenen Laserdiodenstruktur (141) angeordnet ist als an einer in Bruchrichtung (10) hinter der Vertiefung (300) nächstgelegenen Laserdiodenstruktur (141).

4. Verfahren gemäß Anspruch 3,
wobei der Abstand (245) zwischen der Vertiefung (300) und der in Bruchrichtung (10) hinter der Vertiefung (300) nächstgelegenen Laserdiodenstruktur (141) mindestens viermal so groß ist wie der Abstand (240) zwischen der Vertiefung (300) und der in Bruchrichtung (10) vor der Vertiefung (300) nächstgelegenen Laserdiodenstruktur (141), bevorzugt mindestens achtmal so groß.

5. Verfahren gemäß einem der vorhergehenden Ansprüche,
wobei jede der Laserdiodenstrukturen (141) einen Resonator (142) aufweist, der senkrecht zur Bruchrichtung (10) orientiert ist.

6. Verfahren gemäß einem der vorhergehenden Ansprüche,
wobei die Vertiefungen (300) durch Ritzen oder mittels eines Lasers angelegt werden.

7. Verfahren gemäß einem der vorhergehenden Ansprüche,
wobei das Verfahren den folgenden weiteren Schritt aufweist:
- Anlegen einer in der Bruchebene (20) angeordneten Randkerbe (170) an einem in Bruchrichtung (10) vorne liegenden Rand (160) der Halbleiterscheibe (100).

8. Verfahren gemäß einem der vorhergehenden Ansprüche,
wobei der Graben (130) durch Sägen, mittels eines Lasers oder durch einen Ätzprozess angelegt wird.

9. Verfahren gemäß einem der vorhergehenden Ansprüche,
wobei bei mindestens einer Vertiefung (300) die hintere Begrenzungsfläche (220) gegenüber der Oberseite (101) der Halbleiterscheibe (100) um einen Winkel (221) zwischen 100° und 160° geneigt ist, bevorzugt um einen Winkel (221) zwischen 120° und 145°.

10. Verfahren gemäß einem der vorhergehenden Ansprüche,
wobei mindestens eine Vertiefung (300) in zur Oberseite (101) der Halbleiterscheibe (100) senkrechte Richtung (12) eine Tiefe (211) aufweist, die zwischen 5 µm und 80 µm liegt, bevorzugt zwischen 15 µm und 70 µm, besonders bevorzugt zwischen 25 µm und 55 µm.

11. Verfahren gemäß einem der vorhergehenden Ansprüche,
wobei bei der mindestens einen Vertiefung (300) die vordere Begrenzungsfläche (210) gegenüber der Bodenfläche (230) einen Winkel (212) zwischen 75° und 95° einschließt, bevorzugt einen Winkel (212) zwischen 85° und 95° einschließt.

12. Verfahren gemäß einem der vorhergehenden Ansprüche, wobei die Bodenfläche (230) eine Länge (231) aufweist, die zwischen 5 µm und 100 µm liegt, bevorzugt zwischen 15 µm und 80 µm, besonders bevorzugt zwischen 20 µm und 50 µm.

13. Verfahren gemäß einem der vorhergehenden Ansprüche,
wobei die Absatzfläche (320) in Bruchrichtung (10) eine Länge (321) zwischen 5 µm und 100 µm aufweist, bevorzugt eine Länge (321) zwischen 15 µm und 80 µm, besonders bevorzugt eine Länge (321) zwischen 20 µm und 50 µm.

## Claims

1. Method for producing a laser chip (140) comprising the following steps:
- providing a semiconductor wafer (100) comprising a top side (101) and an underside (102),
wherein the semiconductor wafer (100), on the top side, comprises a plurality of integrated laser diode structures (141) which are arranged one behind another along a defined breaking direction (10) that runs perpendicular to the growth direction (12) of the semiconductor wafer;
- creating a plurality of depressions (300) arranged one behind another along the breaking direction (10) on the top side (101) of the semiconductor wafer (100), wherein each depression (300) comprises a front boundary face (210) and a rear boundary face (220) successively in the breaking direction (10),
wherein the depression (300), on its base, has a bottom face (230) that connects the front boundary face (210) to the rear boundary face (220) and is oriented substantially parallel to the top side (101) of the semiconductor wafer (100),
wherein, in the case of at least one depression (300), the rear boundary face (220) encloses an angle (221) of between 95° and 170° with the bottom face (230),
wherein the at least one depression (300) comprises a shoulder (310) adjacent to the rear boundary face (220), wherein the shoulder (310) comprises a shoulder face (320) parallel to the top side (101) of the semiconductor wafer (100) and adjacent to the rear boundary face (220);
- creating a trench (130) running in the breaking direction (10) and arranged in a breaking plane (20) on the underside (102) of the semiconductor wafer (100), wherein the breaking plane (20) is oriented perpendicular to the top side (101) of the semiconductor wafer (100) and runs through the depressions (300);
- breaking the semiconductor wafer (100) in the breaking direction (10) at the breaking plane (20).

2. Method according to Claim 1,
wherein a respective depression (300) is arranged between two adjacent laser diode structures (141).

3. Method according to Claim 2,
wherein at least one depression (300) is arranged closer to a laser diode structure (141) located closest upstream of the depression (300) in the breaking direction (10) than to a laser diode structure (141) located closest downstream of the depression (300) in the breaking direction (10).

4. Method according to Claim 3,
wherein the distance (245) between the depression (300) and the laser diode structure (141) located closest downstream of the depression (300) in the breaking direction (10) is at least four times the magnitude of the distance (240) between the depression (300) and the laser diode structure (141) located closest upstream of the depression (300) in the breaking direction (10), preferably at least eight times the magnitude thereof.

5. Method according to one of the preceding claims,
wherein each of the laser diode structures (141) comprises a resonator (142) oriented perpendicular to the breaking direction (10).

6. Method according to one of the preceding claims, wherein the depressions (300) are created by scribing or by means of a laser.

7. Method according to one of the preceding claims, wherein the method comprises the following further step:
- creating an edge notch (170) arranged in the breaking plane (20) on an edge (160) of the semiconductor wafer (100) that is located at the front in the breaking direction (10).

8. Method according to one of the preceding claims,
wherein the trench (130) is created by sawing, by means of a laser or by an etching process.

9. Method according to one of the preceding claims,
wherein, in the case of at least one depression (300), the rear boundary face (220) is inclined by an angle (221) of between 100° and 160°, preferably by an angle (221) of between 120° and 145°, relative to the top side (101) of the semiconductor wafer (100).

10. Method according to one of the preceding claims,
wherein at least one depression (300) comprises a depth (211) of between 5 µm and 80 µm, preferably of between 15 µm and 70 µm, particularly preferably between 25 µm and 55 µm, in a direction (12) perpendicular to the top side (101) of the semiconductor wafer (100).

11. Method according to one of the preceding claims,
wherein, in the case of the at least one depression (300), the front boundary face (210) encloses an angle (212) of between 75° and 95°, preferably encloses an angle (212) of between 85° and 95°, relative to the bottom face (230).

12. Method according to one of the preceding claims,
wherein the bottom face (230) has a length (231) of between 5 µm and 100 µm, preferably of between 15 µm and 80 µm, particularly preferably of between 20 µm and 50 µm.

13. Method according to one of the preceding claims,
wherein the shoulder face (320) has a length (321) of between 5 µm and 100 µm, preferably a length (321) of between 15 µm and 80 µm, particularly preferably a length (321) of between 20 µm and 50 µm, in the breaking direction (10).

## Revendications

1. Procédé de fabrication d'une puce laser (140), comprenant les étapes suivantes :
- fourniture d'une galette en semiconducteur (100) ayant une face supérieure (101) et une face inférieure (102),
la galette en semiconducteur (100) possédant, sur la face supérieure, une pluralité de structures de diode laser (141) intégrées, lesquelles sont disposées les unes derrière les autres le long d'une direction de rupture (10) spécifiée qui suit un tracé perpendiculaire à la direction de croissance (12) de la galette en semiconducteur ;
- création d'une pluralité de creux (300) disposés les uns derrière les autres le long de la direction de rupture (10) sur la face supérieure (101) de la galette en semiconducteur (100),
chaque creux (300) successif dans la direction de rupture (10) possédant une surface de délimitation avant (210) et une surface de délimitation arrière (220),
le creux (300) possédant sur sa base une surface de fond (230) qui relie la surface de délimitation avant (210) avec la surface de délimitation arrière (220) et qui est orientée sensiblement parallèlement à la face supérieure (101) de la galette en semiconducteur (100), au niveau d'au moins un creux (300), la surface de délimitation arrière (220) formant avec la surface de fond (230) un angle (221) compris entre 95° et 170°, l'au moins un creux (300) possédant un gradin (310) qui se rattache à la surface de délimitation arrière (220), le gradin (310) possédant une surface de gradin (320) parallèle à la face supérieure (101) de la galette en semiconducteur (100), laquelle se rattache à la surface de délimitation arrière (220) ;
- création d'une tranchée (130), qui suit un tracé dans la direction de rupture (10) et est disposée dans un plan de rupture (20), sur la face inférieure (102) de la galette en semiconducteur (100),
le plan de rupture (20) étant orienté perpendiculairement à la face supérieure (101) de la galette en semiconducteur (100) et suivant un tracé à travers les creux (300) ;
- rupture de la galette en semiconducteur (100) dans la direction de rupture (10) au niveau du plan de rupture (20) .

2. Procédé selon la revendication 1, un creux (300) étant respectivement disposé entre deux structures de diode laser (141) voisines.

3. Procédé selon la revendication 2, au moins un creux (300) étant disposé plus près d'une structure de diode laser (141) située la plus proche devant le creux (300) dans la direction de rupture (10) que d'une structure de diode laser (141) située la plus proche derrière le creux (300) dans la direction de rupture (10) .

4. Procédé selon la revendication 3, l'écart (245) entre le creux (300) et la structure de diode laser (141) située la plus proche derrière le creux (300) dans la direction de rupture (10) étant au moins quatre fois plus grand que l'écart (240) entre le creux (300) et la structure de diode laser (141) située la plus proche devant le creux (300) dans la direction de rupture (10), de préférence au moins huit fois plus grand.

5. Procédé selon l'une des revendications précédentes, chacune des structures de diode laser (141) possédant un résonateur (142) qui est orienté perpendiculairement à la direction de rupture (10).

6. Procédé selon l'une des revendications précédentes, les creux (300) étant créés par incision ou au moyen d'un laser.

7. Procédé selon l'une des revendications précédentes, le procédé comprenant l'étape supplémentaire suivante :
- création d'une encoche (170) disposée dans le plan de rupture (20) au niveau d'un bord (160) de la galette en semiconducteur (100) situé à l'avant dans la direction de rupture (10).

8. Procédé selon l'une des revendications précédentes, la tranchée (130) étant créée par sciage, au moyen d'un laser ou par un processus de gravure.

9. Procédé selon l'une des revendications précédentes, au niveau d'au moins un creux (300), la surface de délimitation arrière (220) étant inclinée d'un angle (221) entre 100° et 160° par rapport à la face supérieure (101) de la galette en semiconducteur (100), de préférence d'un angle (221) entre 120° et 145°.

10. Procédé selon l'une des revendications précédentes, au moins un creux (300) possédant, dans la direction (12) perpendiculaire à la face supérieure (101) de la galette en semiconducteur (100), une profondeur (211) qui est comprise entre 5 µm et 80 µm, de préférence entre 15 µm et 70 µm, notamment de préférence entre 25 µm et 55 µm.

11. Procédé selon l'une des revendications précédentes, au niveau de l'au moins un creux (300), la surface de délimitation avant (210) formant, par rapport à la surface de fond (230), un angle (212) entre 75° et 95°, de préférence un angle (212) entre 85° et 95°.

12. Procédé selon l'une des revendications précédentes, la surface de fond (230) présentant une longueur (231) qui est comprise entre 5 µm et 100 µm, de préférence entre 15 µm et 80 µm, notamment de préférence entre 20 µm et 50 µm.

13. Procédé selon l'une des revendications précédentes, la surface de gradin (320) présentant, dans la direction de rupture (10), une longueur (321) entre 5 µm et 100 µm, de préférence une longueur (321) entre 15 µm et 80 µm, notamment de préférence une longueur (321) entre 20 µm et 50 µm.
